# EUROPEAN PATENT APPLICATION

(11) **EP 2 514 517 A1**
(43) Date of publication of application: **24.10.2012**
(21) Application number: 11184332.2
(22) Date of filing: 07.10.2011
(51) Int. Cl.: B01J 8/18, C01B 33/027

(54) **Fluidized bed reactor**

(30) Priority: 20.04.2011 KR 20110036720
(71) Applicant: Silicon Value LLC, Daejon 305-804 (KR)
(72) Inventor: Jung, Yunsub, 157-010 SEOUL (KR); Kim, Keunho, 680-010 ULSAN (KR); Yoon, Yeokyun, 305-770 DAEJEON (KR); Kim, Ted, 302-120 DAEJEON (KR)
(74) Representative: Colombo, Michel

(57) **Abstract**

A fluidized bed reactor is disclosed. The fluidized bed reactor includes a reaction pipe; a flowing-gas supply unit configured to supply flowing gas to an internal space of the reaction pipe by controlling the supply of the flowing gas independently; and a reaction gas supply unit configured to supply reaction gas to the internal space of the reaction pipe.

## Description

### BACKGROUND

### 1. Field

Embodiments may relate to a fluidized bed reactor.

### 2. Background

High purity polycrystal silicon that is useable for a semiconductor device or a solar cell has been consumed broadly. To fabricate such polycrystal silicon, silicon deposition has been used. According to the silicon deposition, silicon contained in reaction gas is deposited by pyrolysis of reaction gas and hydrogen reaction.

Mass production of the polycrystal silicon requires a fluidized bed reactor that is relatively large and high, compared with a conventional fluidized bed reactor used in a laboratory. Because of that, the fluidized bed reactor capable of produce the polycrystal silicon happens to have a large weight and a large volume and it is difficult to fabricate, install and maintain/repair such the fluidized bed reactor.

There have been active studies and researches on a fluidized bed reactor that is able to mass-produce the polycrystal silicon, with efficient fabrication, installation and maintenance.

### SUMMARY

Accordingly, the embodiments may be directed to a fluidized bed reactor. An object of the embodiments is to provide a fluidized bed reactor which is able to supply sufficient heat and flowing gas uniformly in order to deposit silicon.

Another object of the embodiments is to provide a fluidized bed reactor which is able to mass-produce polycrystal silicon and of which assembly, installation and maintenance/repair are smooth and efficient.

To achieve these objects and other advantages and in accordance with the purpose of the embodiments, as embodied and broadly described herein, a fluidized bed reactor includes a reaction pipe; a flowing-gas supply unit configured to supply flowing gas to an internal space of the reaction pipe by controlling the supply of the flowing gas independently; and a reaction gas supply unit configured to supply reaction gas to the internal space of the reaction pipe.

The number of the flowing-gas inlets may be two or more.

The quantity of the flowing gas supplied to the internal space of the reaction pipe by each of the flowing-gas supply units may be the identical or different.

The flowing-gas supply unit may include a flowing-gas inlet to suck flowing gas from outside; a flowing-gas channel connected with a predetermined portion of the flowing-gas inlet; and a flowing-gas nozzle connected with the flowing-gas channel, and an outlet area of the plurality of the flowing-gas nozzles is the identical.

An overall volume of the flowing-gas channel may be identical to or larger than an overall volume of the flowing-gas inlet.

The fluidized bed reactor may further include a lower plate having the flowing-gas channel arranged therein.

The plurality of the flowing-gas nozzles may be arranged in an overall area of the lower plate uniformly.

The area of the lower plate may be divided into a plurality of areas and the number of the flowing-gas nozzles arranged in each of the divided areas is the identical.

The fluidized bed reactor may further include a plurality of flowing-gas channels arranged in the lower plate, corresponding to the divided areas of the lower plate, and the plurality of the flowing-gas channels are connected with the plurality of the flowing gas nozzles, respectively.

Each of the flowing-gas channels may have the identical volume.

The plurality of the flowing-gas inlets and the plurality of the flowing-gas channels may be connected with each other one by one correspondingly, and each of the flowing-gas nozzles may be connected with same number of the flowing-gas nozzles.

Each of the flowing-gas channels may have the identical volume.

An inlet area of the flowing-gas inlet may be identical to or larger than an outlet area of the flowing-gas nozzle.

The number of the flowing-gas inlets may be two or more.

The number of the flowing-gas inlets may be one or more than one, and the number of the flowing-gas nozzles connected with the flowing-gas inlet in communication is at least one.

Therefore, it may be efficient to assemble, install and maintain/repair the fluidized bed reactor according to the embodiments. Spherical-shaped quartz beads may be filled into the bottom part of the fluidized bed reactor smoothly, which accompanies the assembly process, while checking a filling status with the naked eyes.

Furthermore, according to the embodiments, the bottom part of the fluidized bed reactor may be configured of multi-layered plates. Because of that, contamination of polycrystal silicon may be prevented and the assembly, installation and maintenance/repair of the fluidized bed reactor may be more efficient.

A still further, parts composing each of the multi-layered plates provided in the quartz plate may have ends that are alternated from each other. Because of that, prevention of polycrystal silicon may be efficient advantageously and the assembly, installation and maintenance/repair of the fluidized bed reactor may be more efficient may be also efficient.

A still further, the fluidized bed reactor according to the embodiments may prevent the flowing-gas supply unit from separated because of the pressure applied thereto during the high pressure reaction. Because of that, it may be possible to operate the fluidized bed reactor stably.

A still further, the heater arranged to heat the inside of the reaction pipe provided in the fluidized bed reactor according to the embodiments may be insertedly assembled to the fixing part mounted to the bottom part. Because of that, the assembly, installation and maintenance/repair of the fluidized bed reactor may be more efficient may be advantageously simple.

It is to be understood that both the foregoing general description and the following detailed description of the embodiments or arrangements are exemplary and explanatory and are intended to provide further explanation of the embodiments as claimed.

### BRIEF DESCRIPTION OF THE DRAWINGS

Arrangements and embodiments may be described in detail with reference to the following drawings in which like reference numerals refer to like elements and wherein:

FIG. 1 illustrates a fluidized bed reactor according to an exemplary embodiment;

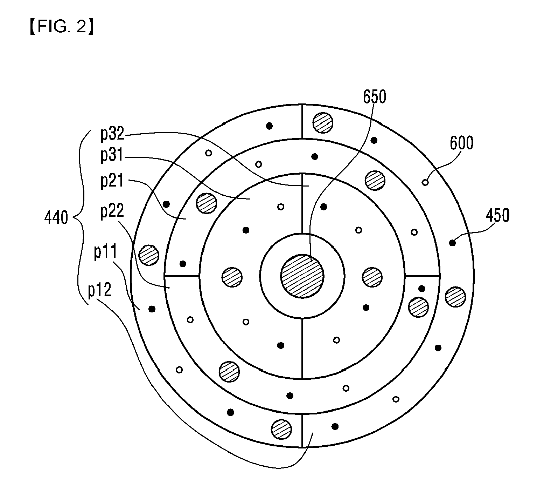

FIG. 2 is a diagram illustrating an example of a plate provided in the fluidized bed reactor according to the embodiment;

FIG. 3 is a diagram illustrating another example of the plate provided in the fluidized bed reactor according to the embodiment;

FIGS. 4a and 4b are plane views illustrating a flowing-gas supply unit the provided in the fluidized bed reactor according to the embodiment;

FIG. 5 is a diagram illustrating an assembly structure of the flowing-gas supply unit provided in the fluidized bed reactor according to the embodiment;

FIG. 6 illustrates various examples of the gas supply unit provided in the fluidized bed reactor according to the embodiment; and

FIGS. 7a and 7b illustrate a connection structure between a first reaction pipe and a second reaction pipe according to the embodiment.

### DETAILED DESCRIPTION

Reference may now be made in detail to specific embodiments, examples of which may be illustrated in the accompanying drawings. Wherever possible, same reference numbers may be used throughout the drawings to refer to the same or like parts.

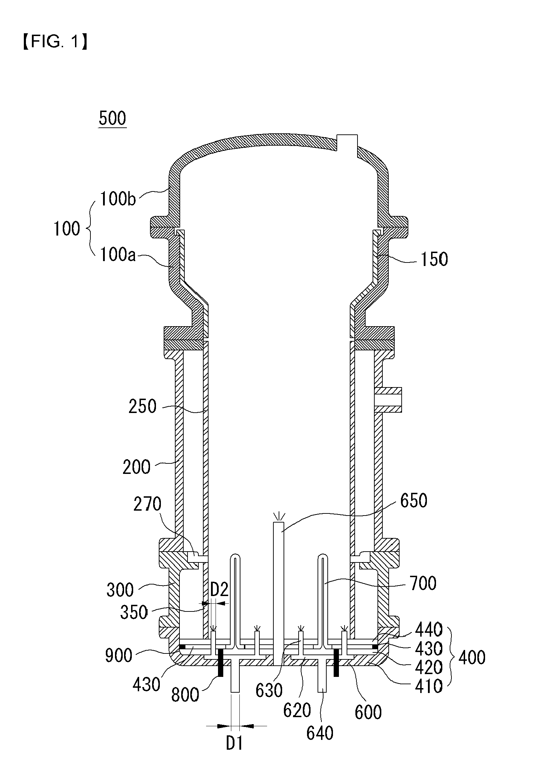

FIG. 1 illustrates a fluidized bed reactor according to an exemplary embodiment. As shown in FIG. 1, a fluidized bed reactor 500 according to an exemplary embodiment may include a head 100, a first body part 200, a second body part 300 and a bottom part 400.

The head 100 may be connected with the first body part 200 and it may have a larger diameter than a diameter of a first reaction pipe 250 provided in the first body part 200. When gas and microelements pass the head 100 from the first reaction pipe 250, a velocity of gas and microelements may decrease because of the larger diameter possessed by the head 100.

As a result, load of a post-process for the exhausted gas or microelements may be reduced. An inner wall of the head 100 may be formed of an inorganic material that will not be transformed at a high temperature. For example, the inner wall of the head 100 may be formed of at least one of quartz, silica, silicon nitride, boron nitride, zirconia, silicon carbide, graphite, silicon and vitreous carbon.

Also, at least one of coating or lining that uses an organic polymer may be performed to the inner wall of the head 100, if it is possible to cool an outer wall of the head 100.

When the inner wall of the head 100 is formed of a carbon containing material such as silicon carbide, graphite and vitreous carbon, polycrystal silicon may be contaminated by carbon impurities. Because of that, silicon, silica, quartz or silicon nitride may be coated or lined on the inner wall of the head 100 which could contact with the polyscrystal silicon.

For example, the head 100 may include a plurality of heads 100a and 100b. A lining layer 150 may be located on an inner surface of the fist head 1 00a.

The first body part 200 may be located under the head 100, connected with the head 100, and it may provide a predetermined space where polycrystal silicon deposition reaction may occur.

The second body part 300 may be located under the first body part 200, with connected with the first body part 200. Together with the first body part 200, the second body part 300 may provide a predetermined space where at least one of polycrystal silicon deposition reaction or heating reaction may occur.

Those first and second body parts 200 and 300 may be independently provided and they may be coupled to each other to provide a reaction space. Alternatively, the first and second body parts 200 and 300 may be integrally formed with each other.

The bottom part 400 may be located under the second body part 300, with connected with the second body part 300. A variety of nozzles 600 and 650, a heater 700 and an electrode 800 may be coupled to the bottom part 400 for the polycrystal silicon deposition.

At this time, the head 100, the first body part 200 and the second body part 300 may be formed of a proper metal material that is easy to treat with good mechanical strength and rigidity such as carbon steel, stainless steel and various steel alloys. A protection layer for the first and second body parts 200 and 300 formed of the material mentioned above may be formed of metal, organic polymer, ceramic or quartz.

When fabricating the head 100, the first body part 200 and the second body part 300, a gasket or a sealing material may be used to shut off the inside of the reactor from external space. Each of the first and second body parts 200 and 300 may have a variety of shapes including a cylindrical pipe, a flange, a tube, a fitting, a plate, a corn, an oval or a jacket having a cooling medium flowing between double-framed walls,

Also, when the head 100, the first body part 200 and the second body part 300 are formed of the metal material, a protection layer may be coated on an inner surface possessed by each of them or a protection pipe or a protection wall may be installed additionally. The protection layer, pipe or wall may be formed of a metal material. However, a non-metal material such as organic polymer, ceramic and quartz may be coated or lined on the protection layer, pipe or wall to prevent contamination inside the reactor.

The first and second body parts 200 and 300 may be maintained blow a predetermined range of temperatures by cooling fluid such as water, oil, gas and air, to prevent heat expansion, to protect workers and to prevent accidents. Inner or outer walls of components provided in the first and second body parts 200 and 300 that need cooling may be fabricated to allow the cooling fluid to circulate there through.

In the meanwhile, an insulator may be arranged on an outer surface of each of the first and second body parts 200 and 300 to protect workers and to prevent too much heat loss.

As mentioned above, it might be difficult to fabricate, install and maintain/repair the fluidized bed reactor in case of increasing the size and height of the fluidized bed reactor for the mass production of the polycrystal silicon. In other words, if fabricating, installing and maintaining/repairing a fluidized bed reactor including a reaction pipe and a single body part, that is large-sized, high and heavy, it might be difficult to treat the body part and the body part might damage after colliding with a nozzle or a reaction pipe. In contrast, the fluidized bed reactor according to the embodiment may include the plurality of the body parts 200 and 300 and the reaction pipes 250 and 350. Because of that, it may be smooth and each to fabricate, install and maintain/repair the fluidized bed reactor.

As follows, a process of assembling the fluidized bed reactor according to the embodiment will be described.

A first reaction pipe 250 may be assembled to be located inside the first body part 200 and a second reaction pipe 350 may be assembled to be located inside the second body part 300. Various nozzles 600 and 650, an electrode 800 and a heater 700 are assembled to the bottom part 400 configured to close a bottom of the second body part 300 airtight. The bottom part 400 may be connected with a lower area of the second body part 300 having the second reaction pipe 350 provided therein. After that, the first body part 200 and the second body part 300 may be connected with each other and the head 100 may be connected with the first body part 200.

Various gas supply units assembled to the bottom part 400 may include a flowing-gas supply unit 600 and a reaction gas supply unit 650.

The first and second reaction pipes 250 and 350 may be tube-shaped or partially tube-shaped, corn-shaped and oval-shaped. Each end of the first and second reaction pipes 250 and 350 may be processed to be a flange type. The first and second reaction pipes 250 and 350 may be configured of a plurality of parts and some of the parts may be arranged on inner walls of the first and second body parts 200 and 300 as liners.

The first and second reaction pipes 250 and 350 may be formed of an inorganic material that is not transformed easily at a high temperature. The inorganic material may be quartz, silica, silicon nitride, boron nitride, zirconia, yttria, silicon carbide, graphite, silicon, vitreous carbon and a compound of them.

When the first and second reaction pipes 250 and 350 are formed of a carbon containing material such as silicon carbide, graphite, vitreous carbon and the like, the carbon containing material might contaminate the polycrystal silicon. Because of that, silicon, silica, quartz, silicon nitride and the like may be coated or lined on each inner wall of the first and second reaction pipes that can contact with the polycrystal silicon.

The flowing-gas supply unit 600 may be configured to supply flowing-gas that enables silicon particles to flow within the reaction pipe. Some or all of the silicon particles may flow with the flowing-gas. At this time, the flowing-gas may include at least one of hydrogen, nitrogen, argon, helium, hydrogen chloride (HCl), silicon tetra chloride (SiCl₄). The flowing-gas supply unit 600 may be a tub, a liner or a molded material.

Such the flowing-gas supply unit 600 may include a flowing-gas inlet, a flowing-gas nozzle 620 and a flowing-gas channel 630. An end of the flowing-gas channel may be connected with an opposite end of the flowing-gas inlet and the other end of the flowing-gas channel may be connected with the other end of the flowing-gas inlet.

Flowing-gas may be drawn into the flowing-gas supply unit via the flowing-gas inlet 640 from the outside and the flowing-gas may be supplied to the flowing-gas channel 630. The flowing-gas nozzle 620 may supply the flowing-gas filled in the channel 630 to the inside of the reaction pipe 100.

At this time, an overall volume of the flowing-gas channel 630 may be identical to or larger than an overall volume of the flowing-gas inlet. The flowing-gas channel may be a space filled with the flowing gas drawn from the outside and it may be formed in a lower plate 410, which will be described later.

Also, although not shown in the drawings, the flowing-gas supply unit 600 may include a flowing-gas tub, instead of the flowing-gas channel 630. In other words, the flowing-gas inlet 640 may supply the flowing gas drawn from the outside to the flowing-gas tub. The flowing-gas nozzle 620 may supply the flowing gas filled in the flowing-gas tub to the inside of the reaction pipe 250. At this time, the flowing-gas tube may be space filled with the flowing gas drawn from the outside and it may be formed in the lower plate.

In the meanwhile, the flowing-gas channel 630 or the flowing-gas tube may be located between the flowing-gas inlet 640 and the flowing-gas nozzle 620. This is because the flow of the flowing-gas supplied by the flowing-gas nozzles 620 connected with the flowing-gas channel had better be uniformly dispersed.

In other words, the size of the fluidized bed reactor has to be large for the mass production of polycrystal silicon and an internal space of the reaction pipe 100 may be large accordingly. When the internal space of the reaction pipe 100 is increased, the supply of the flowing gas has to be also increased and the number of the flowing-gas nozzles 620 may be increased.

When the dimension of the fluidized bed reactor is enlarged, the flowing-gas nozzles 620 have to supply the flowing gas to the inside of the reaction pipe 100 uniformly. If the supply of the flowing gas is not uniform, flow of the silicon fluidized bed would be unstable and the transmission of the heat generated by the flowing gas fails to be uniform. Because of that, the silicon deposition reaction may be performed unstably.

As a result, the uniform supply of the flowing gas may enable the heat, which will be used for the silicon deposition, to be transported into the reaction pipe 100 uniformly and also it may the flow of the silicon fluidized bed performed stably.

For the flowing-gas nozzles 620 to supply the flowing gas to the inside of the reaction pipe 100 uniformly, flowing gas may be filled into the flowing-gas channel 630 or the flowing-gas tube connected with the flowing-gas nozzles spatially.

When the flow of the flowing gas drawn via the flowing-gas inlet 640 is larger than or identical to the flow of the flowing gas exhausted via the flowing-gas nozzles 620, the flowing gas may be dispersed in the flowing-gas channel 630 or the flowing-gas tube uniformly and the flow of the flowing gas exhausted via the flowing-gas nozzles 620 may be then unformed. At this time, outlet areas of the flowing-gas nozzles may be identical to each other.

According to the embodiment, an inlet area (D1) of the flowing-gas inlet 640 may be larger than the sum total of outlet areas (D2) of the flowing-gas nozzles 620, to make the flow of the flowing-gas drawn via the flowing-gas inlet 640 larger than or identical to the flow of the flowing gas exhausted via the flowing-gas nozzles 620. In the meanwhile, according to the embodiment, the flowing-gas inlet may be connected with the flowing-gas nozzle via the flowing-gas channel. Alternatively, the flowing-gas inlet may be directly connected with the flowing-gas nozzle not via the flowing-gas channel, such that it may supply the flowing gas transported from the outside to the reaction pipe.

The reaction gas supply unit 650 may be configured to supply reaction gas that containing silicon elements to a silicon particle layer. The reaction gas is raw material gas that is used in deposition of polycrystal silicon and it may include silicon elements. The reaction gas may include at least one of monosilan (SiH₄), disilane (Si₆H₆), higher-silane (SiₙH₂ₙ₊₂, 'n' is a 3 or more a natural number), dichlide silane (SCS: SiH₂Cl₂), trichlide silane (TCS: SiHCl₃), tetra chlide silane (STC: SiCl₄), dibromosilane (SiH₂Br₂), tribromo silane (SiHBr₃), silicontetrabromide (SiBr₄), diiodosilane (SiH₂I₂), triiodosilane (SiHl₃) and silicontetraiodide (SiI₄). At this time, the reaction gas may further include at least one of hydrogen, nitrogen, argon, helium or hydrogen chloride. As the reaction gas is supplied, polycrystal silicon is deposited on a surface of a seed crystal having a size of 0.1 to 2mm and the size of the polycrystal silicon may be increased. When the size of the polycrystal silicon is increased up to a preset value, the reaction gas may be exhausted outside the fluidized bed reactor.

The heater 700 may supply heat that is used for generating silicon deposition reaction on the surface of the polycrysal silicon within the fluidized bed reactor 500. According to the embodiment, the heat used for the silicon deposition reaction may be generated in the reaction pipe. Alternatively, the heat generated outside the reaction pipe 250 may be supplied to the inside of the reaction pipe 250 and the heat may be used for the silicon deposition reaction. The heater 700 may include a resistant to be supplied electricity, to generate and supply the heat. The heater 700 may include at least one of graphite, ceramic such as and a metal material.

The gas supply units 600 and 650, that is, various nozzles, the electrode 800 and the heater 700 may be assembled to the bottom part 400, together with plates 410 to 440 composing the bottom part 400. As shown in the drawings, the bottom part 400 according to the embodiment may include a lower plate 410 and first to third plates 420, 430 and 440.

The lower plate 410 may be connected with the second body part 300, having the flowing-gas supply unit and the reaction gas supply unit assembled thereto. The lower plate 410 may be formed of a metal material that is easy and efficient to process, with an excellent mechanical strength and rigidity, such as carbon steel, stainless steel and alloy steel. The first plate 420 may be located on the lower plate 410, to insulate the lower plate 410. Because of that, the first plate 420 may be formed of a proper material that may be resistant against a high temperature, without contaminating the deposited polycrystal silicon and even with an insulation property, such as quartz. The first plate 420 may be formed of a ceramic material such as silicon nitride, alumina and yttria, rather than quartz. If necessary, such a ceramic material may be coated or lined on a surface of the first plate 420.

The second plate 430 may be located on the first plate 420 and it may be in contact with the heater 700 to supply electricity to the heater 700. Because of that, the second plate 430 may be formed of a conductive material such as graphite, graphite having silicon carbide coated thereon, silicon carbide and graphite having silicon nitride coated thereon. The first plate 420 having the insulation property may be located between the lower plate 410 and the second plate 430, such that the lower plate 410 may be insulated from the second plate 430. The second plate 430 may be in contact with the heater 700 and heat may be generated from the second plate 430. However, the second plate 430 may have a relatively large sectional area where electric currents flow, compared with a sectional area of the heater where electric currents flow. Because of that, the heat generated in the second plate 430 may be much smaller than the heat generated in the heater 700. Also, to reduce the heat generated in the second plate 430, a graphite sheet may be insertedly disposed between the second plate 430 and the heater 700.

When the lower plate 410 and the second plate 430 have conductivity, a leakage current might be generated by the contact between the lower plate 410 and the second plate 430 and the leakage current might flow to the lower plate 410. Because of that, an end of the lower plate 410 may be spaced apart a proper distance from an end of the second plate 430 as shown in FIGS. 1a and 1b.

In other words, a recess may be formed in the first plate 420 and the second plate 430 may be seated in the recess. For example, a recess having an identical to or larger length as the length of the second plate 430 may be formed in the first plate 420 and the second plate may be seated in the recess of the first plate 420. As a result, a proper area of the first plate 420 may be positioned between the lower plate 410 and the end of the second plate 430, to maintain the insulation between the lower plate 410 and the second plate 430.

As shown in the drawings, the lower plate 410 and the second plate 430 may be insulated from each other by the first plate 420. Alternatively, an insulation ring 900 may be arranged around a rim of the second plate 430, to insulate the lower plate 410 from the second plate 430. At this time, the insulation ring 900 may be formed of quartz and ceramic.

The third plate 440 may be located on the second plate 430 to prevent the polycrystal silicon deposited from the first and second reaction pipes 250 and 350 from being contaminated from the second plate 430, with an insulation property. Because of that, the third plate 440 may be formed of an inorganic material that may not be transformed at a high temperature, namely, high-temperature-resist. The inorganic material may be quartz, silica, silicon nitride, boron nitride, zirconia, silicon carbide, graphite, silicon, vitreous carbide or a compound of them. When the third plate 440 is formed of the carbon containing material such as silicon carbide, graphite and vitreous carbon, the carbon containing material might contaminate the polycrystal silicon. Silicon, silica, quartz, silicon nitride and the like may be coated or lined on a surface of the third plate 440.

Also, each of the second plate and the third plates 440 composing the bottom part 400 may include a plurality of unit-plates, not as a single body. Because of that, the assembly, installation and maintenance of the fluidized bed reactor may be more smooth and efficient. In other words, the size of the fluidized bed reactor is increased for the mass production of polycrystal silicon. When each of the second and third plates 430 and 440 is formed as a single body, the assembly, installation and maintenance of the fluidized bed reactor may be difficult.

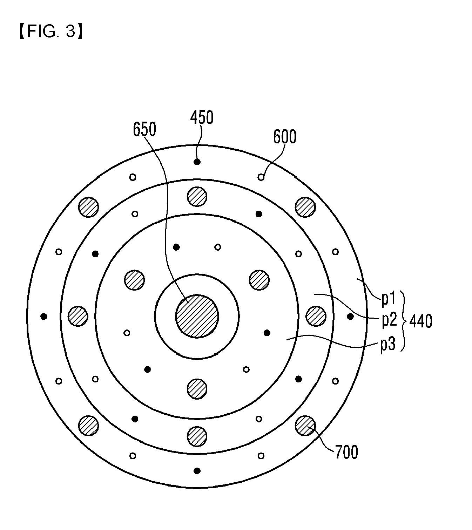

For example, as shown in FIG. 1c, the third plate 440 may be configured of pieces cut away along concentric and diameter directions with respect to the third plate 440. As shown in FIG. 3, the third plate 440 may be configured of ring-shaped pieces having different sizes.

According to an assembling structure between the plates and the heater provided in the fluidized bed reactor, the lower plate 410, the third plate 420, the second plate 430 and the third plate 440 may be fixed, specifically, fastened by fastening means passing through the lower plate 410, the third plate 420, the second plate 430 and the third plate 440. The plurality of the plates 410 to 440 composing the lower part 400 may be fastened to each other by the fastening means passing through the plates 410 to 440. Such the fastening means may be formed of an inorganic material that may not be easily transformed at a high temperature. The inorganic material may be quartz, silica, silicon nitride, boron nitride, zirconia, silicon or a compound of them. When the fastening means is formed of a carbon containing material such as silicon carbide, graphite, vitreous carbon, silicon, silica, quartz and silicon nitride may be coated or line on a surface of the fastening means to prevent the carbon containing material from contaminating the polycrystal silicon or a cap formed of silicon, silica, quartz and silicon nitride may be provided on the fastening means. The fastening means may be coupled to the plurality of the plates 410 to 440 by a screw.

In the meanwhile, a fixing part may be arranged in the bottom part 400 to which the heater 700 will be assembled. The fixing part such as a pin or clip may be coupled to a perforation formed in the second plate 430 out of the plates that is connected with the heater 700. A plurality of grooves may be formed in the heater 700 to insert the fixing part therein. A manufacture or user may pressingly insert the heater 700 to the fixing part, to fix the heater 700 to the bottom part 400. As a result, a fastening process that uses a screw and a bolt may not need in the assembling process of the heater 700 and the heater 700 may be assembled more simply. The heater 700 according to this embodiment has "U"-shaped and two of the fixing part may be required for a single heater 700. However, the number of the fixing parts may be variable according to the shape of the heater 700. The fixing part may be formed of a proper material having a good electrical conductivity and a good docility such as graphite or metal.

The second plate 430 may include a plurality of unit-plates and the lower portion of the heater 700 may be in contact with neighboring unit-plates. Because of that, electricity may be supplied to the heater 700 via the unit-plates of the second plate 430. At this time, the heater 700 may include a projection extended from the lower portion of the heater, at which the heater 700 is connected with the lower part 400, along a perpendicular direction with respect to a longitudinal direction of the heater 700. The projection of the heater 700 may be hooked to the third plate 440 at the same time, to fix the heater 700 more stably. The neighboring unit-plates may be insulated from each other. For example, an insulative material may be disposed between the unit-plates provided in the second plate 430 in contact with the lower portion of the heater 700. The insulative material may insulate between the unit-plates in contact with the lower portion of the heater 700, to prevent generation of leakage currents. The unit plates will be described in detail later. The heater 700 according to the embodiment may include a large surface area per unit volume. A corrugated portion may be formed in a surface of the heater 700 to enhance heating efficiency. Rather than the corrugation, various types of protrusions or patterns may be formed in the surface of the heater 700 to enlarge the surface area to enhance the heating efficiency. As a result, at least one of the corrugation, protrusion and pattern may be formed in the surface of the heater 700.

After the fixing part is inserted in the heater 700, a heater cap may cover a profile of the heater 700 to prevent exposure of the heater 700 to prevent the contamination of the polycrystal silicon.

To perform such a function of the heater cap, the heater cap may be formed of an inorganic material that is not easily transformed at a high temperature. The inorganic material may be quartz, silica, silicon nitride, boron nitride, zirconia, yttria, silicon and a compound of them. When the heater cap is formed of a carbon containing material, silicon, silica, quartz and silicon nitride may be coated or lined on the surface of the heater cap to prevent the contamination of the polycrystal silicon that might be generated by the carbon containing material.

The heater cap may include a hooking protrusion extended along a longitudinal direction with respect to the longitudinal direction of the heater cap. The hooking protrusion of the heater cap may be hooked between unit-plates of the third plate 440.

The fluidized bed reactor according to the embodiment may include heater groups. Each of heater groups may be connected with two electrodes 800 and the electricity consumed by the heater groups may be identical. The electrode 800 may be formed of graphite, silicon carbide, metal or a compound of them. The electrode 800 may have a shape of a cable, a pole, a rod, a molded-material, a socket, a coupler, a bar, a braided wire or combination of them. At this time, two of the heater groups may be connected with a single electrode 800. In case of n-tuple heaters ("n" is a natural number of 2 or more), the fluidized bed reactor may include n-tuple electrodes 800.

For example, electric resistances of the heater groups may be identical to each other. In other words, the number of the heaters 700 possessed by each of the heater groups may be fixed and resistances of the heaters 700 possessed by each of the heater groups may be identical. When the number of the heaters 700 possessed by each of the heater groups is identical to the number of the heater possessed by the other, the assembly, installation and maintenance/repair of the fluidized bed reactor may be more smooth and efficient. Even when resistances of heaters 700 composing heater groups are different from each other, the heaters 700 may be arranged properly to make resistances of the heater groups identical to each other and then the electricity consumed by the heater groups may be identical to each other. Because of that, the heat may be supplied to the fluidized bed reactor 500 uniformly.

As mentioned above, as the fluidized bed reactor is getting enlarged for the mass production of polycrystal silicon, an internal area of the fluidized bed reactor may be getting enlarged. As a result, the heater groups have to supply heat to the internal area of the fluidized bed reactor uniformly. The heater groups provided in the fluidized bed reactor according to this embodiment may heat the entire internal area of the fluidized bed reactor uniformly, and the fluidized bed reactor may mass-produce polycrystal silicon products having a good quality.

Electric voltage having different phases may be supplied to the heater groups, respectively. For example, in case the fluidized bed reactor includes three heater groups, electric voltages having three different phases may be supplied to the heater groups, respectively. At this time, a phase difference among the phases may be 120°C.

The electric voltages supplied to the heater groups may be controlled independently, to allow each of the heater groups to consume the same electricity. For example, when electric resistances of each heater groups are different from electric resistances of the other or it is difficult to supply the same electricity, a single-phased electric voltage having a different size may be supplied to each of the heater groups to allow each of the heater groups to consume the same electricity.

In case of supplying a multi-phased power voltage, neighboring two of the heater groups may share the electrodes 800 with the others. In case of supplying a single-phased electric voltage, one of the heater groups may be connected with two of the electrodes 800 that are not shared with the other heater groups.

As mentioned above, the heater 700 may be in contact with the unit-plates insulated from each other by the insulative material. For example, an end of the heater 700 may be connected one of the unit-plates and the other end of the heater 700 may be connected with another unit-plate. Because of that, heaters of the heater group may be connected in serial.

The material used to form the heater 700 may be same as the material used to form the unit-plates. For example, the material used to form the heater and the unit-plates is described above and description of the material will be omitted accordingly.

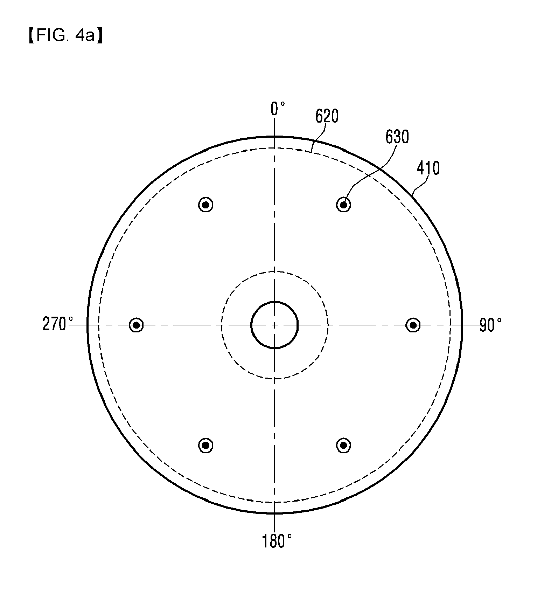

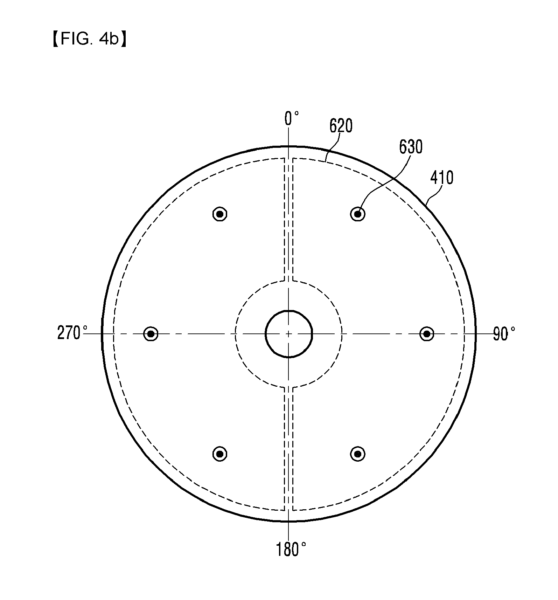

FIGS. 4a and 4b are plane views illustrating the flowing-gas supply unit provided in the fluidized bed reactor according to an embodiment.

As shown in FIGS. 4a and 4b, at least one flowing-gas channel 630 may be formed in the lower plate 410.

When the plurality of the flowing-gas channels 620 are formed in a stand as shown in FIG. 4a, a predetermined number of flowing-gas nozzles 630 may be connected with the flowing-gas channel 620 spatially.

As shown in FIG. 4a, the plurality of the flowing-gas nozzles 630 connected with the single flowing-gas channel 620 may be arranged in an overall area of the lower plate uniformly. Because of that, the flowing gas may be supplied to the internal space of the reaction pipe uniformly and production yield of the polycrystal silicon deposition may be enhanced.

As shown in FIG. 4b, the plurality of the flowing-gas channels 620 may be arranged in the lower plate, physically separated from each other. At this time, a predetermined number of the entire flowing-gas nozzles 630 may be connected with the flowing-gas channel 620 spatially.

In other words, the plurality of the flowing-gas channels 620 may be arranged in the lower plate 410 and the plurality of the flowing-gas nozzles 630 may be dispersed in an area of the lower plate 410. In this case, it may be much more efficient to supply the flowing gas to the internal space of the reaction pipe 250 uniformly.

In the meanwhile, if the flowing gas is supplied by the flowing-gas nozzles 630 connected with the single flowing-gas channel 620, a volume of the flowing-gas channel 620 results in increasing and the pressure of the flowing gas may be different according to positions of the flowing-gas nozzles 630.

However, when the plurality of the flowing-gas channels 620 are provided, the volume of each channel may be reduced and the flow of the flowing gas supplied by the flowing-gas nozzles 630 connected with the plurality of the flowing-gas channels may be uniform stably.

For the uniform supply of the flowing gas, the volume of each flowing-gas channel may be identically fixed. According to this embodiment, the volumes of the flowing-gas channels 620 may be identical to each other and the present embodiment may not be limited thereby. The embodiment may be applicable to a fluidized bed reactor with the glowing-gas channels 620 having different volumes, respectively.

FIG. 4b shows that only two flowing-gas channels 620 are provided to divide a concentric lower plate area into two areas. However, the flowing-gas channels 620 may be arranged to divide the concentric lower plate area into more than two areas. For example, a single flowing-gas channel may be arranged for each quadrant area.

At this time, each of the flowing-gas channels 620 may be connected with the same number of the flowing-gas nozzles 630 and the embodiment may not be limited thereby. Each of the flowing-gas channels 620 may be connected with a different number of the flowing-gas nozzles 630.

Alternatively, the flowing-gas channels 620 may be connected with the flowing-gas inlets one by one or a single flowing-gas channel 620 may be connected with the plurality of the flowing-gas inlets. Because of that, the flowing-gas inlet and the flowing-gas nozzle may be connected with each other in communication by the flowing-gas channel.

When the plurality of the flowing-gas channels 620 are provided, the flow of the flowing gas sucked via the flowing-gas inlets connected with the flowing-gas channels 620 may be controlled independently.

In other words, when the flow of the flowing gas supplied from a specific area of the reaction pipe 250 is different from the flow of the flowing gas supplied to another area of the reaction pipe 250, the flow of the flowing gas supplied via a flowing-gas inlet connected with a flowing-gas channel 630 corresponding to the specific area may be increased or decreased, to supply the flowing gas to the internal space of the reaction pipe 250 more uniformly.

The number of the flowing-gas inlet connected with the flowing-gas channel may be adjusted according to efficiency of a method for controlling the flow of flowing gas. For example, a single flowing-gas inlet may be connected with a single flowing-gas channel or a plurality of flowing-gas inlets may be connected with a single flowing-gas channel.

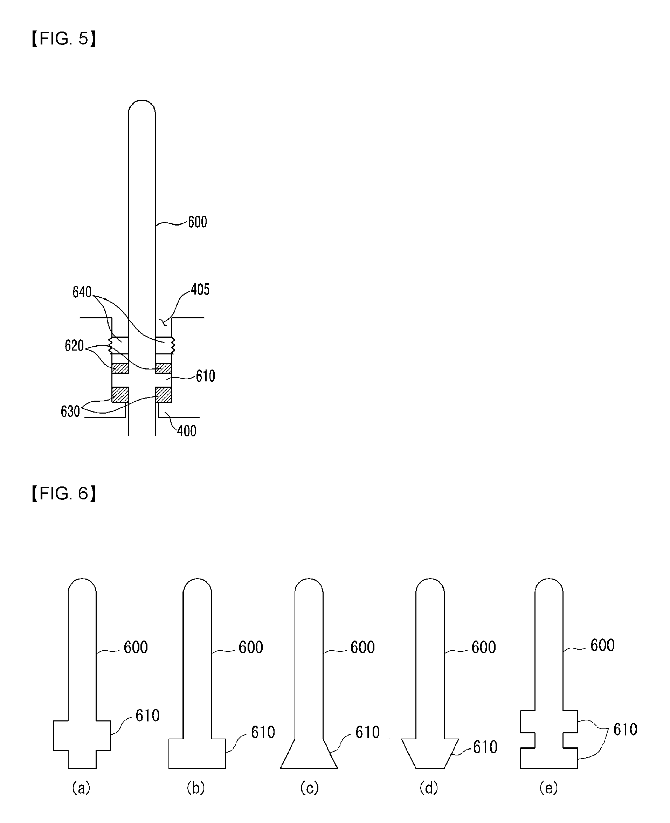

FIG. 5 illustrates an assembling structure of the flowing-gas supply unit provided in the fluidized bed reactor according to the embodiment.

As shown in FIG. 5, a protrusion 610 may be formed in the flowing-gas supply unit 600 to fix the flowing-gas part 600 and a hole 405 may be formed in the bottom part 400 of the fluidized bed reactor to seat the flowing-gas supply unit 600 therein.

A first packing 620 and a second packing 630 may be arranged in an upper area and a lower area of the protrusion 610, respectively. The first packing 620 and the second packing 630 may surround the protrusion 610 of the flowing-gas supply unit 600, to protect the flowing-gas unit 600 from an external shock. In addition, the first packing 620 and the second packing 630 may enable the flowing-gas supply unit 600 assembled stably enough to provide stable sealing.

A screw thread may be formed in an entire area or a proper area of a surface of the hole 405. A bushing 640 having a screw thread formed in an outer surface thereof may be screw-fastened to the screw thread formed in the surface of the hole 405 after the flowing-gas supply unit 600 is seated in the hole 405 together with the packings 620 and 630. The screw-fastened bushing 640 may prevent separation or movement of the flow-gas supply unit 600 which might be generated by a high-pressured-flowing-gas during the operation of the fluidized bed reactor.

FIG. 6 illustrates various modified examples of the flowing-gas supply unit provided in the fluidized reactor according to the embodiment.

(a) and (b) of FIG. 6 illustrate a flowing-gas supply unit 600 including a flange 610 with a preset thickness. (c) of FIG. 6 illustrates a flowing-gas nozzle 600 including a flange with a decreasing thickness toward a lower portion of the flowing-gas supply unit in contact with the bottom part 400. (d) of FIG. 6 illustrates a flowing-gas supply unit including a flange with a gradually increasing thickness toward a lower portion of the flowing-gas supply unit. (e) of FIG. 6 illustrates a flowing-gas supply unit including a plurality of flanges with a preset fixed thickness.

The space defined by the second reaction pipe 350 and the bottom part 400 may include a space occupied by the heater 700 and the other space. The other space may be filled with beads. A predetermined space between beads may be employed as a channel where the flowing-gas passes and the beads may disperse the flowing-gas inside the fluidized bed reactor uniformly. The bead may spherical-shaped, overall-shaped, fillet-shaped, nugget-shaped, tube-shaped, rod-shaped, ring-shaped or combinational-shaped. The bead may be formed of high purity silicon or the same material used to form the reaction pipes 250 and 350. The size of the bead may be larger than a diameter of a product outlet through which the polycrystal silicon is exhausted outside the fluidized bed reactor. An average diameter of the bead may be more than 5mm less than 50mm. As a result, the beads may not be exhausted outside via the product outlet.

The fluidized bed reactor according to the embodiment may include the first body part 200 and the second body part 300. Because of that, the assembly, installation and maintenance/repair of the fluidized bed reactor may be smooth and efficient. When the beads are filled in a status of the first and second body parts 200 and 300 being assembled to each other, an overall height of the first and second body parts 200 and 300 may be substantially high to make it difficult to fill the beads. Also, falling beads happen to damage or break the heater 700, the nozzle or the first and second reaction pipes 250 and 350 located in the fluidized bed reactor. However, according to the embodiment, the beads may be filled into the space defined by the second reaction pipe 350 and the bottom part 400 before the first and second body parts 200 and 300 are assembled to each other. As a result, the filling process of the beads may be performed stably.

After filling the beads, the second body part 300 may be assembled to the first body part 200. As the second body part 300 is assembled to the first body part 200, the first reaction pipe 250 inserted in the first body part 200 may be connected with the second reaction pipe 350 inserted in the second body part 300.

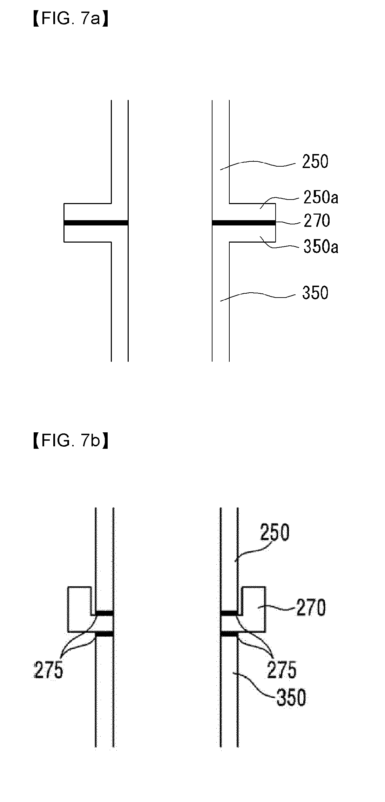

FIGS. 7a and 7b illustrate a connection structure between the first reaction pipe and the second reaction pipe.

As shown in FIG. 7a, the first reaction pipe 250 and the second reaction pipe 350 may include projections 250a and 350a, respectively, and the projections 250a and 350a may be projected toward the first and second body parts 200 and 300 from ends of the first and second reaction pipes 250 and 350, respectively. Here, the projection 250a of the first reaction pipe 250 may face the projection 350a of the second reaction pipe 350 in opposite. Because of that, a contact area between the first and second reaction pipes 250 and 350 may be enlarged enough to reduce the possibility of damage when the first and second reaction pipes 250 and 350 are connected with each other.

As shown in FIG. 7b, a supporting ring 270 may be disposed between the first and second reaction pipes 250 and 350, considering durability weakness of the first and second reaction pipes 250 and 350. The supporting ring 270 may be formed of an inorganic material that is not transformed at a high temperature. For example, the inorganic material may be quartz, silica, silicon nitride, boron nitride, zirconia, silicon carbide, graphite, silicon, vitreous carbon or a compound of those materials. When the supporting ring 270 is formed of the material containing carbon such as silicon carbide, graphite and vitreous carbon, the carbon containing material might contaminate the polycrystal silicon. Because of that, silicon, silica, quartz, silicon nitride and the like may be coated or lined a surface of the supporting ring 270 that contacts the polycrystal silicon. A sealing material 275 may be finished on the supporting ring 270.

The sealing material 275 formed in a sheet, knit or felt shape may be located between the first reaction pipe 250 and the second reaction pipe 350 as shown in FIG. 7a or between the supporting ring 270 and the first reaction pipe 250 as shown in FIG. 7b and between the supporting ring 270 and the second reaction pipe 350.

The sealing material 275 may be formed of a fibrous material containing silicon, to have a high temperature strength and an anti-contamination property.

According to the embodiment, the first reaction pipe 250 and the second reaction pipe 350 may be provided for convenience of assembly, installation and maintenance. Here, there may be a predetermined gap between the first reaction pipe 250 and the second reaction pipe 350.

The sealing material 275 according to the embodiment may close the gap between the first reaction pipe 250 and the second reaction pipe 350 and it may prevent silicon particles from leaking outside. In addition, when connecting the first reaction pipe 250 and the second reaction pipe 350 with each other, the sealing material 275 may reduce a danger of damage.

The space formed between the first body part 200 and the first reaction pipe 250 and the space formed between the second body part 300 and the second reaction pipe 350 may be filled with an inert gas that may not react with the polycrystal silicon such as hydrogen, nitrogen, argon and helium.

To shut off leakage of the heat, which will be transported to the inside of the fluidized bed reactor, an inorganic insulator may be arranged in the space between the first body part 200 and the first reaction pipe 250, the space between the second body part 300 and the second reaction pipe 350 or the other required spaces. The shape of the insulator may be a cylinder, a block, a fabric, a blanket, a felt, a blowing agent and a filling layer.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to affect such feature, structure, or characteristic in connection with other ones of the embodiments. Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A fluidized bed reactor comprising:
a reaction pipe;
a flowing-gas supply unit configured to supply flowing gas to an internal space of the reaction pipe by controlling the supply of the flowing gas independently; and
a reaction gas supply unit configured to supply reaction gas to the internal space of the reaction pipe.

2. The fluidized bed reactor claimed in claim 1, wherein the number of the flowing-gas inlets is two or more.

3. The fluidized bed reactor claimed claim 1 or 2, wherein the quantity of the flowing gas supplied to the internal space of the reaction pipe by each of the flowing-gas supply units is the identical or different.

4. The fluidized bed reactor claimed in claim 1 or 3, wherein the flowing-gas supply unit comprises,
a flowing-gas inlet to suck flowing gas from outside;
a flowing-gas channel connected with a predetermined portion of the flowing-gas inlet; and
a flowing-gas nozzle connected with the flowing-gas channel, and
an outlet area of the plurality of the flowing-gas nozzles is the identical.

5. The fluidized bed reactor claimed in claim 4, wherein an overall volume of the flowing-gas channel is identical to or larger than an overall volume of the flowing-gas inlet.

6. The fluidized bed reactor claimed in claim 4, further comprising:
a lower plate having the flowing-gas channel arranged therein.

7. The fluidized bed reactor claimed in claim 6, wherein the plurality of the flowing-gas nozzles are arranged in an overall area of the lower plate uniformly.

8. The fluidized bed reactor claimed in claim 7, wherein the area of the lower plate is divided into a plurality of areas and the number of the flowing-gas nozzles arranged in each of the divided areas is the identical.

9. The fluidized bed reactor claimed in claim 8, further comprising:
a plurality of flowing-gas channels arranged in the lower plate, corresponding to the divided areas of the lower plate, and
the plurality of the flowing-gas channels are connected with the plurality of the flowing gas nozzles, respectively.

10. The fluidized bed reactor claimed in claim 9, wherein each of the flowing-gas channels has the identical volume.

11. The fluidized bed reactor claimed in claim 4, wherein the plurality of the flowing-gas inlets and the plurality of the flowing-gas channels are connected with each other one by one correspondingly, and
each of the flowing-gas nozzles is connected with same number of the flowing-gas nozzles.

12. The fluidized bed reactor claimed in claim 11, wherein each of the flowing-gas channels has the identical volume.

13. The fluidized bed reactor claimed in claim 4, wherein an inlet area of the flowing-gas inlet is identical to or larger than an outlet area of the flowing-gas nozzle.

14. The fluidized bed reactor claimed in claim 13, wherein the number of the flowing-gas inlets is two or more.

15. The fluidized bed reactor claimed in claim 4, wherein the number of the flowing-gas inlets is one or more than one, and
the number of the flowing-gas nozzles connected with the flowing-gas inlet in communication is at least one.
